# EUROPEAN PATENT SPECIFICATION

(11) **EP 3 758 044 B1**
(45) Date of publication and mention of the grant of the patent: **26.02.2025**
(21) Application number: 20178416.2
(22) Date of filing: 05.06.2020
(51) Int. Cl.: H01J 37/32, C23C 16/50, H05H 1/24, C23C 16/452, C23C 16/455, C23C 16/509, C23C 16/513

(54) **PLASMA IN A SUBSTRATE PROCESSING APPARATUS**
PLASMA IN EINER SUBSTRATVERARBEITUNGSVORRICHTUNG
PLASMA DANS UN APPAREIL DE TRAITEMENT DE SUBSTRAT

(30) Priority: 25.06.2019 FI 20195560
(43) Date of publication of application: 30.12.2020
(73) Proprietor: Picosun Oy, 02150 Espoo (FI)
(72) Inventor: HOLM, Niklas, 02430 Masala (FI); SUZUKI, Toshiya, 02430 Masala (FI)
(74) Representative: Espatent Oy

(56) References cited:
- EP-A1- 2 694 700
- EP-A1- 2 765 217
- EP-B1- 2 694 700
- WO-A1-02/062114
- WO-A1-02/062115
- US-A- 4 943 345
- US-A1- 2005 178 746

## Description

### FIELD OF THE INVENTION

The present invention generally relates to substrate processing methods and apparatus. More particularly, but not exclusively, the invention relates to plasma-enhanced atomic layer deposition (ALD) reactors.

### BACKGROUND OF THE INVENTION

This section illustrates useful background information without admission of any technique described herein representative of the state of the art. The described reactor structure can however be better understood, for example, by considering the granted patent US 9,095,869 B2.

In chemical deposition methods, such as atomic layer deposition (ALD), plasma can be used to provide required additional energy for surface reactions. The use of a plasma source, however, may cause certain requirements or specific problems for the deposition reactor. One such problem is that reactive species in plasma have a limited lifetime. The documents WO 02/062115 A1 and WO 02/062114 A1 disclose a plasma system having a high frequency inductively coupled plasma jet source. The document US 2005/178746 A1 disclose a method and system to obtain a high power density plasma. The document EP 2765217 A1 discloses a remote plasma generation apparatus. The document US 4943345 A discloses an apparatus and method for treating a substrate with an excited species removed from a plasma.

### SUMMARY

It is an object of certain embodiments of the invention to cope with the limited lifetime of plasma or at least to provide an alternative to existing technology.

According to a first example aspect of the invention there is provided a method according to claim 1, comprising:
introducing plasma species via a plasma in-feed line into a reaction chamber for a deposition target in a substrate processing apparatus, wherein the plasma in-feed line goes via a plasma formation section,
the method being characterized in that it comprises speeding up velocity of plasma species within the plasma in-feed line and downstream from the plasma in-feed line by a constriction of a tubular form providing a straight cylindrical channel downstream of the plasma formation section, wherein the constriction within the plasma in-feed line reduces a cross-sectional flow area of the plasma in-feed line by at least 8 %.

In certain embodiments, the constriction is in the form of a straight channel. In certain embodiments, the constriction forms a straight channel having a non-changing diameter. In certain embodiments, the constriction forms a straight channel having a non-changing diameter over its length. In certain embodiments, the constriction forms a straight channel of a cylindrical shape. In certain embodiments, the constriction forms a straight channel having a length along which the channel diameter is constant. In the embodiments, the constriction is a tubular item or of a tubular form. In the embodiments, the constriction reduces a cross-sectional flow area of the in-feed line by at least 8 %.

In certain embodiments, the constricted cross-sectional flow area is 92 % of the cross-sectional flow area before the constriction, or less. In certain preferable embodiments, the constricted cross-sectional flow area is 75 % of the cross-sectional flow area before the constriction, or less. In certain preferable embodiments, the constricted cross-sectional flow area is 50 % of the cross-sectional flow area before the constriction, or less. In certain preferable embodiments, the constricted cross-sectional flow area is 25 % of the cross-sectional flow area before the constriction, or less. In certain preferable embodiments, the constricted cross-sectional flow area is within the range from 10 % to 75 % of the cross-sectional flow area before the constriction. In certain preferable embodiments, the constricted cross-sectional flow area is within the range from 20 % to 60 % of the cross-sectional flow area before the constriction. In certain preferable embodiments, the constricted cross-sectional flow area is within the range from 40 % to 50 % of the cross-sectional flow area before the constriction.

The term "cross-sectional flow area before the constriction" herein means the cross-sectional flow area of the in-feed line (flow channel) immediately preceding the constriction (e.g., the cross-sectional flow area of the plasma source tube).

In certain preferred embodiments, the flow rate of plasma gas entering the plasma formation section is within the range from 500 sccm to 10000 sccm, preferably from 4000 sccm to 10000 sccm.

In certain preferred embodiments, a plasma power within the range from 10 W to 10000 W, preferably from 300 W to 1000 W, more preferably from 300 to 500 W, or from 1000 W to 10000 W, more preferably from 2000 W to 10000 W, yet more preferably from 3000 W to 10000 W is applied to the plasma formation section.

In certain preferred embodiments, a plasma formation period with a duration within the range from 0.1 seconds to 60 seconds is applied.

In certain preferred embodiments in which the uniformity of a deposited thin film is to be optimized, the duration of a plasma pulse, i.e., duration of the plasma formation period is within the range from 5 seconds to 10 seconds, the flow rate of plasma gas is within the range from 500 sccm to 10000 sccm, preferably from 4000 sccm to 10000 sccm, and optionally the plasma power is within the range from 300 W to 1000 W, preferably from 300 W to 500 W. In certain preferred embodiments in which film quality in terms of low leakage current through the film is to be optimized, the duration of the plasma formation period is within the range from 20 seconds to 40 seconds, the flow rate of plasma gas is within the range from 500 sccm to 10000 sccm, preferably from 4000 sccm to 10000 sccm, and optionally the plasma power is within the range from 1000 W to 10000 W, preferably from 2000 W to 10000 W, more preferably from 3000 W to 10000 W.

In certain preferred embodiments, a purge period of a non-plasma precursor with a duration within the range from 1 second to 8 seconds, more preferably from 4 seconds to 8 seconds, is applied.

In certain preferred embodiments in which the uniformity of a deposited thin film is to be optimized, the duration of the purge period of a non-plasma precursor is within the range from 4 seconds to 8 seconds, the flow rate of plasma gas is within the range from 500 sccm to 10000 sccm, preferably from 4000 sccm to 10000 sccm, and optionally the plasma power is within the range from 300 W to 1000 W, preferably from 300 W to 500 W, and optionally the plasma formation period has a duration within the range from 5 seconds to 10 seconds. In certain preferred embodiments in which film quality in terms of low leakage current through the film is to be optimized, the duration of the purge period of a non-plasma precursor is within the range from 4 seconds to 8 seconds, the flow rate of plasma gas is within the range from 500 sccm to 10000 sccm, preferably from 4000 sccm to 10000 sccm, and optionally the plasma power is within the range from 1000 W to 10000 W, preferably from 2000 W to 10000 W, more preferably from 3000 W to 10000 W, and optionally the plasma formation period has a duration within the range from 20 seconds to 40 seconds.

In certain preferred embodiments, the flow rate of plasma gas entering the plasma formation section is within the range from 500 sccm to 10000 sccm, a plasma power within the range from 10 W to 10000 W is applied to the plasma formation section, a plasma formation period with a duration within the range from 0.1 seconds to 60 seconds is applied, and a purge period of a non-plasma precursor with a duration within the range from 1 second to 8 seconds is applied.

In certain preferred embodiments, the flow rate of plasma gas entering the plasma formation section is within the range from 4000 sccm to 10000 sccm, a plasma power within the range from 300 W to 1000 W, preferably from 300 W to 500 W, is applied to the plasma formation section, a plasma formation period with a duration within the range from 5 seconds to 10 seconds is applied, and a purge period of a non-plasma precursor with a duration within the range from 4 seconds to 8 seconds is applied.

In certain preferred embodiments, the flow rate of plasma gas entering the plasma formation section is within the range from 4000 sccm to 10000 sccm, a plasma power within the range from 1000 W to 10000 W, preferably from 2000 W to 10000 W, more preferably from 3000 W to 10000 W is applied to the plasma formation section, a plasma formation period with a duration within the range from 20 seconds to 40 seconds is applied, and a purge period of a non-plasma precursor with a duration within the range from 4 seconds to 8 seconds is applied.

In certain embodiments, plasma reactant gas is excited by RF (radio frequency) radiation. In certain embodiments, plasma reactant gas is excited by microwave radiation. In certain embodiments, the plasma reactant gas is fed into a plasma source tube without injecting. In certain embodiments, the plasma reactant gas optionally together with carrier and/or inert gas is fed into a plasma source tube without injecting the gas into the plasma source tube. Accordingly, the plasma reactant gas optionally together with carrier and/or inert gas is conducted into the plasma source tube along a (regular) pipeline (i.e., without special injection arrangements). The pipeline in certain embodiments comprises at least one valve (or plasma reactant pulsing valve).

In certain embodiments, the plasma in-feed line comprises a vertical plasma source tube comprising the plasma formation section. In certain embodiments, the plasma in-feed line goes along a vertical path through the plasma formation section and the constriction.

In certain embodiments, a jet nozzle inlet liner is provided to implement the constriction. In certain embodiments, the jet nozzle inlet liner is a tubular item. In certain embodiments, the inner diameter of the part is essentially smaller than the inner diameters of other parts of the gas introduction. It has been observed that gas velocity increases inside the part since its cross section is smaller than the plasma source tube and the reaction chamber. The increase may be based on, for example, a choked flow effect. It has also been observed that gas velocity is not only increased inside the inlet liner but also at a relatively long distance downstream the inlet liner, and even close to the deposition target. An obtained jet flow is minimizing the delivery time from plasma source to deposition target. The jet flow in certain embodiments is in contact with surrounding gas and thus a contact surface area with solid material is minimal. This further improves reactive species (or plasma species) delivery to the deposition target since the average lifetime of reactive species is getting longer.

In certain embodiments, the constriction is implemented by an inlet part. In certain embodiments, the inlet part comprises a tubular part with a smaller inner diameter than the in-feed line (or with a smaller inner diameter than the plasma source tube). In certain embodiments, the inlet part comprises a tubular part that is chemically inert. In certain embodiments, the inlet part comprises a tubular part that is electrically insulating. In certain embodiments, the inlet part comprises an outer part or tube housing an inner tube.

In certain embodiments, the method comprises providing the constriction as a converging nozzle arrangement or as a converging-diverging nozzle arrangement. In certain embodiments, the method comprises: surrounding the reaction chamber by a vacuum chamber. In certain embodiments, the method comprises: performing sequential self-saturating surface reactions on a substrate surface in the reaction chamber.

According to a second aspect of the invention there is provided a substrate processing apparatus according to claim 9, comprising:
a reaction chamber;
a plasma in-feed line to introduce plasma species into the reaction chamber for a deposition target, wherein
the plasma in-feed line goes via a plasma formation section,
the apparatus being characterized in that the plasma in-feed line comprises a constriction of a tubular form providing a straight cylindrical channel downstream of the plasma formation section to speed up velocity of plasma species within the plasma in-feed line and downstream from the plasma in-feed line, wherein the constriction within the plasma in-feed line is configured to reduce a cross-sectional flow area of the plasma in-feed line by at least 8 %.

In the embodiments, the constriction reduces a cross-sectional flow area of the in-feed line by at least 8 %.

In certain embodiments, the apparatus comprises a plasma source. In certain embodiments, the plasma source is positioned upstream of the constriction. In certain embodiments, the plasma source comprises a plasma source tube (a tube travelling across the plasma source). In certain embodiments, plasma species is generated within the plasma source tube. In certain embodiments, an inlet part providing the constriction and the plasma source tube are concentric parts.

In certain embodiments, the apparatus comprises the plasma in-feed line in between the plasma source and the deposition target to introduce plasma species into the reaction chamber for the deposition target.

In certain embodiments, the deposition target is positioned within the reaction chamber. In certain embodiments, the deposition target is a substrate. In certain embodiments, the deposition target is a batch of substrates. In certain embodiments, the substrate is a wafer. In certain embodiments, the substrates in the batch of substrates are vertically oriented.

In certain embodiments, an inlet part providing the constriction is positioned between the plasma source and the reaction chamber. In certain embodiments, the plasma source is a remote plasma source. In certain embodiments, the plasma source is positioned on the outside of the reaction chamber.

In certain embodiments, the plasma species comprises gaseous plasma. In certain embodiments, the plasma species comprises radicals. In certain embodiments, the plasma species comprises ions.

In certain embodiments, the inlet part is centrally positioned within the plasma in-feed line. In certain embodiments, the inlet part has a narrower inner diameter than the other parts / remaining parts in the plasma in-feed line. In certain embodiments, the plasma in-feed line has at its narrowest inner diameter within the inlet part. In certain embodiments, the inlet part provides for the narrowest channel width of the plasma in-feed line.

In certain embodiments, the inlet part is in the form of an inlet liner with a holder for the inlet liner. In certain embodiments, the inlet liner is a tubular item. In certain embodiments, the inlet liner is transparent to visible light. In certain embodiments, the inlet liner is chemically inert. In certain embodiments, the inlet liner (inner tube) is electrically insulating. In certain embodiments, inlet part comprises an inner tube surrounded by an outer tube or outer part. In certain embodiments, the inner tube and the outer tube are concentric parts. In certain embodiments, the inner tube and the outer tube have a ring-like cross-section. In certain embodiments, the inner tube and the outer tube are tightly fitted against each other. In certain embodiments, the outer part or outer tube forms a holder for the inner tube. In certain embodiments, the outer part or outer tube is electrically conductive. In certain embodiments, the outer part or outer tube is applied with an appropriate electric potential, such as system ground. In certain embodiments, the inlet part is attached in between pipe portions.

In certain embodiments, the inlet part is a removable part. In certain embodiments, the inner tube is a removable part. In certain embodiments, the inlet part provides the plasma in-feed line with a sudden constriction, or a stricture, to enhance gas velocity. In certain embodiments, the inlet part provides the plasma in-feed line with a stepwise narrowing of flow path. In certain embodiments, the inlet part is followed by an expansion space expanding towards the reaction chamber. In certain embodiments, the flow path from the plasma source to the reaction chamber undergoes a stepwise expansion (or widening) at an interface or in connection with an interface between the inlet part and the expansion space. In certain embodiments, the inlet part is a non-actuated part, for example, not a valve. In certain embodiments, the inlet part is a passive part (i.e., non-active part). In certain embodiments, the cross-sectional area of the plasma in-feed line (expansion space) immediately after (or downstream of) the inlet part is larger than the cross-sectional area of the plasma in-feed line (plasma source tube) immediately before (or upstream of) the inlet part.

In certain embodiments, the reaction chamber is surrounded by a vacuum chamber.

In certain embodiments, the apparatus is configured to perform sequential self-saturating surface reactions on a substrate surface in the reaction chamber. In certain embodiments, the apparatus is configured to apply plasma-assisted atomic layer deposition.

According to a further example aspect there is provided a method, comprising:
introducing plasma species via a plasma in-feed line into a reaction chamber for a deposition target in a substrate processing apparatus; and
speeding up gas velocity within the plasma in-feed line by an inlet part.

According to a further example aspect there is provided a substrate processing apparatus, comprising:
a reaction chamber;
a plasma in-feed line to introduce plasma species into the reaction chamber for a deposition target, wherein
the plasma in-feed line comprises an inlet part configured to speed up gas velocity.

Different non-binding example aspects and embodiments have been illustrated in the foregoing. The above embodiments are used merely to explain selected aspects or steps that may be utilized in implementations of the present invention. Some embodiments may be presented only with reference to certain example aspects. It should be appreciated that corresponding embodiments apply to other example aspects as well. Any appropriate combinations of the embodiments may be formed The invention is defined by the claims.

### BRIEF DESCRIPTION OF THE DRAWINGS

The invention will now be described, by way of example only, with reference to the accompanying drawings, in which:
- Fig. 1: shows an apparatus in accordance with certain embodiments;
- Fig. 2: shows an apparatus in accordance with further embodiments;
- Fig. 3: shows the apparatus of Fig. 2 in a loading position;
- Fig. 4: shows an inlet part in accordance with certain embodiments;
- Fig. 5: shows simulation results of gas velocity in an apparatus in accordance with certain embodiments;
- Figs. 6-10: show simulation results of gas velocity in an apparatus with modified geometries;
- Fig. 11: shows certain dimensions of the apparatus shown in Figs. 5-10;
- Fig. 12: shows a process timing diagram in accordance with certain embodiments;
- Fig. 13: shows another representation of the timing diagram;
- Fig. 14: shows another representation of the apparatus in accordance with certain embodiments;
- Figs. 15a-15d: further demonstrate the operation of the apparatus in accordance with certain embodiments;
- Fig. 16: shows a block diagram of a control system in accordance with certain example embodiments;
- Fig. 17: shows a schematic drawing of an apparatus with a converging nozzle arrangement in accordance with certain example embodiments; and
- Fig. 18: shows a schematic drawing of an apparatus with a converging-diverging nozzle arrangement in accordance with certain example embodiments.

### DETAILED DESCRIPTION

In the following description, Atomic Layer Deposition (ALD) technology is used as an example.

The basics of an ALD growth mechanism are known to a skilled person. ALD is a special chemical deposition method based on sequential introduction of at least two reactive precursor species to at least one substrate. A basic ALD deposition cycle consists of four sequential steps: pulse A, purge A, pulse B and purge B. Pulse A consists of a first precursor vapor and pulse B of another precursor vapor. Inactive gas and a vacuum pump are typically used for purging gaseous reaction by-products and the residual reactant molecules from the reaction space during purge A and purge B. A deposition sequence comprises at least one deposition cycle. Deposition cycles are repeated until the deposition sequence has produced a thin film or coating of desired thickness. Deposition cycles can also be either simpler or more complex. For example, the cycles can include three or more reactant vapor pulses separated by purging steps, or certain purge steps can be omitted. Or, as for plasma-assisted ALD, for example PEALD (plasma-enhanced atomic layer deposition), discussed herein one or more of the deposition steps can be assisted by providing required additional energy for surface reactions through plasma in-feed, or one of the reactive precursors can be substituted by plasma energy, the latter leading to single precursor ALD processes. Accordingly, the pulse and purge sequence may be different depending on each particular case. The deposition cycles form a timed deposition sequence that is controlled by a logic unit or a microprocessor. Thin films grown by ALD are dense, pinhole free and have uniform thickness.

As for substrate processing steps, the at least one substrate is typically exposed to temporally separated precursor pulses in a reaction vessel (or chamber) to deposit material on the substrate surfaces by sequential self-saturating surface reactions. In the context of this application, the term ALD comprises all applicable ALD based techniques and any equivalent or closely related technologies, such as, for example the following ALD sub-types: MLD (Molecular Layer Deposition), plasma-assisted ALD, for example PEALD (Plasma Enhanced Atomic Layer Deposition) and photon-enhanced Atomic Layer Deposition (known also as flash enhanced ALD or photo-ALD).

However, the invention is not limited to ALD technology, but it can be exploited in a wide variety of substrate processing apparatuses, for example, in Chemical Vapor Deposition (CVD) reactors, or in etching reactors, such as in Atomic Layer Etching (ALE) reactors.

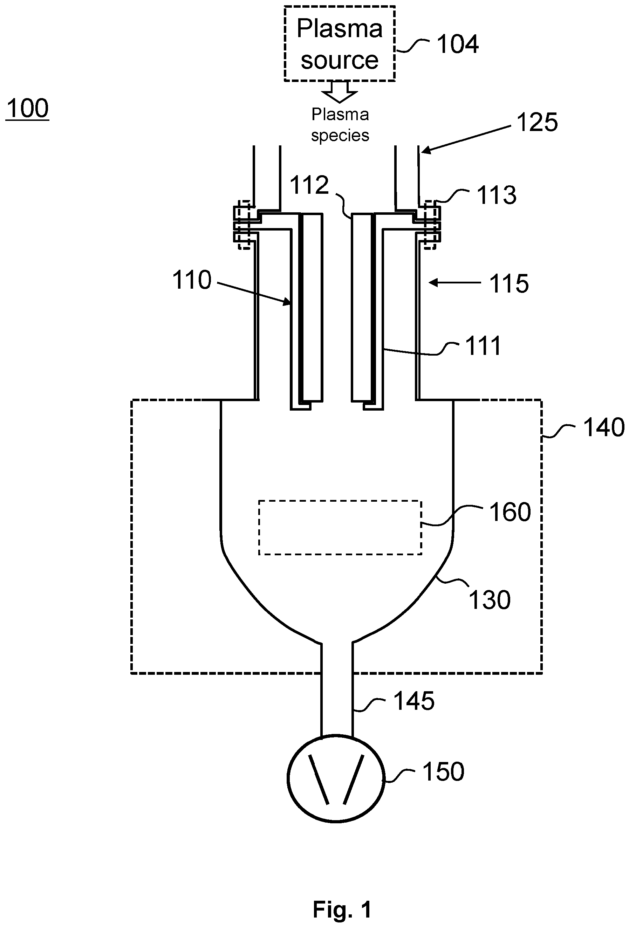

Fig. 1 shows an apparatus 100 in accordance with certain embodiments. The apparatus 100 is a substrate processing apparatus which may be, for example, a plasma-assisted ALD reactor. The apparatus comprises a reaction chamber 130 and an in-feed line (or in-feed arrangement) 115 to introduce plasma, for example gaseous plasma, for a deposition target 160 positioned in the reaction chamber 130. The deposition target 160 may be a substrate (or wafer) or a batch of substrates.

The apparatus 100 further comprises an exhaust line 145 leading to a vacuum pump 150. The reaction chamber 130 may be in the general form of a cylinder that is rounded at its bottom, or it may be adopted to any other substrate shape. The exhaust line 145 in certain embodiments is positioned in the rounded bottom of the reaction chamber 130. The vacuum pump 150 provides a vacuum for the reaction chamber 130. The apparatus in certain embodiments comprises an outer chamber, a vacuum chamber 140 around the reaction chamber 130. Inactive shield gas may be fed into an intermediate space in between the vacuum chamber 140 and the reaction chamber 130. The pressure within the intermediate space is kept, by pumping, on a higher level compared to prevailing pressure within the reaction chamber 130. The same vacuum pump 150 or another pump may be used to arrange an outgoing flow (of inactive gas) from the intermediate space.

The plasma in-feed 115 into the reaction chamber 130 is arranged from a plasma source, or a remote plasma source. The in-feed occurs from the top side of the reaction chamber 130. Plasma species travel from plasma source tube 125 in a downward direction. In certain embodiments, the plasma source tube 125 forms part of the in-feed line 115. The in-feed line 115 comprises a constriction provided by an inlet part 110 that is configured to speed up gas velocity. In certain embodiments, the inlet part 110 is positioned downstream of the plasma source tube 125. In certain embodiments, the inlet part 110 is a tubular part having a narrower inner diameter than the plasma source tube 125 preceding the inlet part 110. In certain embodiments, the plasma source tube 125 forms part of the plasma source. In certain embodiments, there may be another pipe portion in between the plasma source tube 125 and the inlet part 110.

When the plasma species enters the inlet part 110 its velocity increases. The delivery time to the deposition target 160 is respectively reduced.

The inlet part 110 may be formed of an outer part or tube 111 housing an inner tube 112 providing the constriction. The outer tube 111 may be made of metal, for example. An example material is aluminum or steel. It may be an electrically conductive part. The inner tube 112 may be chemically inert. In certain embodiments, the inner tube 112 is made of quartz. In certain embodiments, the inner tube 112 is made of sapphire. The inner tube 112 may be electrically insulating. The outer tube 111 may comprise an inwardly protruding shape in its bottom portion for the inner tube 112 to rest on. Further, the outer tube 111 may contain an outwardly protruding shape in its top portion for fixing the inlet part 110 in between pipe portions by fixing means 113 or similar. The inner tube 112 may be an inlet liner for the outer tube 111. The inner tube 112 may form a jet nozzle inlet liner.

In certain embodiments, the inlet part 110 has an input opening for receiving the plasma species into inside of the inner tube 112 in a top portion of the inlet part 110. The inner tube 112 provides a straight cylindrical channel for the plasma species to flow downwards until an output opening in a bottom portion of the inlet part 110 outputs the plasma species with the increased velocity from the inside of the inner tube 112 into inside of the reaction chamber 130 (however, in other embodiments, the inlet part 110 may alternatively output the plasma species into an intermediate part positioned in between the inlet part 110 and the reaction chamber 130 so that the plasma species enter the reaction chamber 130 only via the intermediate part).

In certain embodiments, as shown in Fig. 1, upon outputting the plasma species into inside of the reaction chamber 130 the plasma species experiences a step-like (stepwise) enlargement of the flow path. Accordingly, in certain embodiments, the flow path after the enlargement is sideways limited by the cylindrical wall of the reaction chamber 130.

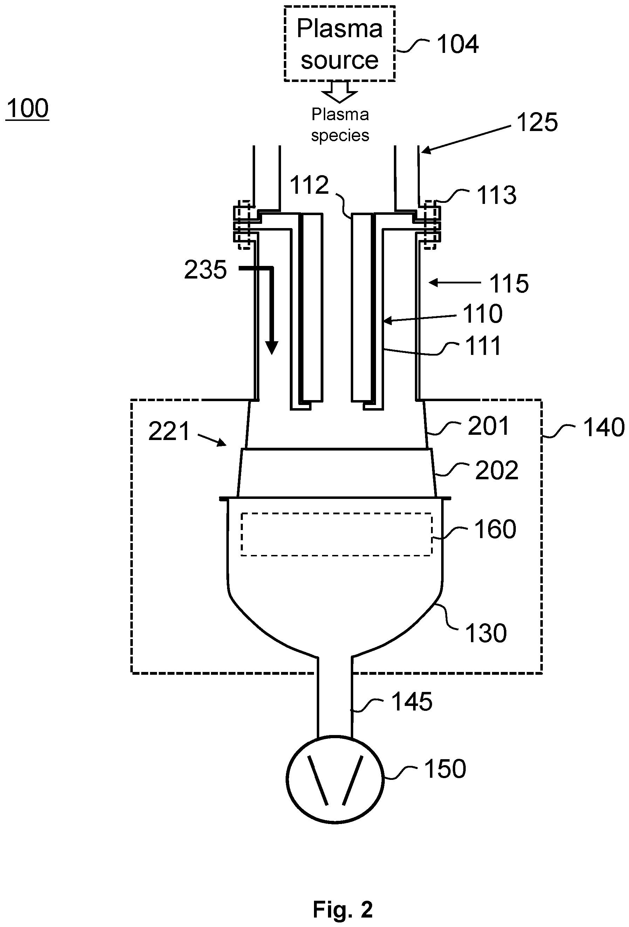

Fig. 2 shows an apparatus 200 in accordance with certain embodiments. The apparatus 200 and its operation generally corresponds to that of apparatus 100. Therefore, a reference is made to the preceding description. However, in the embodiment shown in Fig. 2, further features relating to substrate loading and unloading is presented.

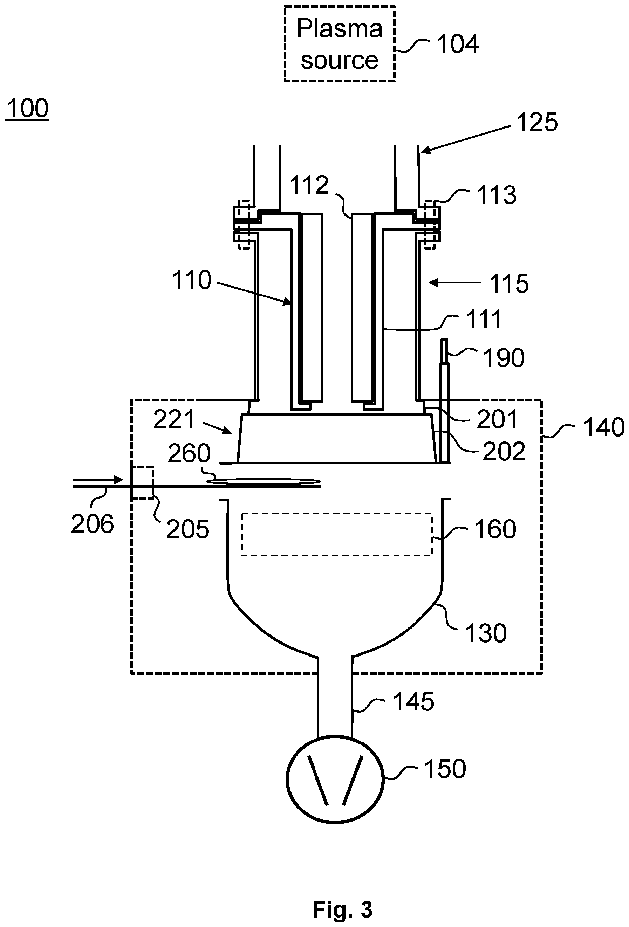

A deformable in-feed part 221 (as an intermediate part) is positioned in between the inlet part 110 and the deposition target 160. The deformable in-feed part 221 has a closed configuration for substrate processing, for example, by plasma-assisted ALD and an open configuration for substrate loading. In the closed configuration, the in-feed part 221 may be in an extended shape, and in the open configuration in a contracted shape. The closed configuration is depicted in Fig. 2 and the open configuration in Fig. 3.

The deformable in-feed part 221 comprises a set of nested sub-parts or ring-like members which are movable to fit within each other. In the embodiment shown in Figs. 2 and 3, the number of sub-parts is two. The sub-parts 201 and 202 form a telescopic structure. In the example embodiment shown in Fig. 2 and 3, the upper sub-part 201 is attached to a wall of the vacuum chamber 140. The attachment may be in a top wall of the vacuum chamber 140 or in another appropriate point depending on the embodiment. In other embodiments, the upper sub-part may be attached to an outlet of the inlet part 110. A gradually widening flow path from the inlet part 110 into inside of the reaction chamber 130 may in that way be provided instead of the step-like enlargement. In certain embodiments, such as shown in Figs. 2 and 3, the lower sub part 202 either closes an interface between the lower sub part 202 and the reaction chamber 130 (or reaction chamber wall) as depicted in Fig. 2 or provides for a loading gap for substrate loading into the reaction chamber 130 as depicted in Fig. 3.

As shown in Fig. 3, a retractable shaft of an elevator 190 is attached to the deformable in-feed part 221 or in connection with it. The elevator 190 operates the deformable in-feed part 221. A substrate 260 (or a batch of substrates) is loaded into the reaction chamber 130 via a loading port 205 by a loader 206 (an end effector, a loading robot or similar) through the loading gap formed by vertically deforming the in-feed part 221 into its open configuration.

The plasma species travels as a vertical flow from the plasma source through the plasma source tube 125 and through the inlet part 110 with an increased velocity to the output opening or outlet of the inlet part 110 and therefrom along the gradually widening flow path to the deposition target 160 (in the reaction chamber 130).

In certain embodiments, a protective inert gas flow 235 is provided in a downward direction around the inlet part 110 (see Fig. 2).

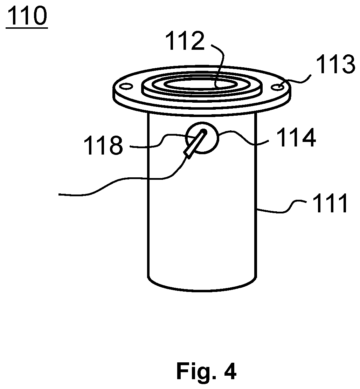

Fig. 4 shows the inlet part 110 in accordance with certain embodiments. The inlet part 110 comprises the outer tube 111 housing the inner tube or inlet liner 112. The inlet part 110 optionally comprises an opening 114 radially extending through the whole outer tube 111 of at least one side (but not through the inner tube 112) for viewing the plasma from a side direction. In certain embodiments, a pressure sensor 118 is positioned within the opening 114.

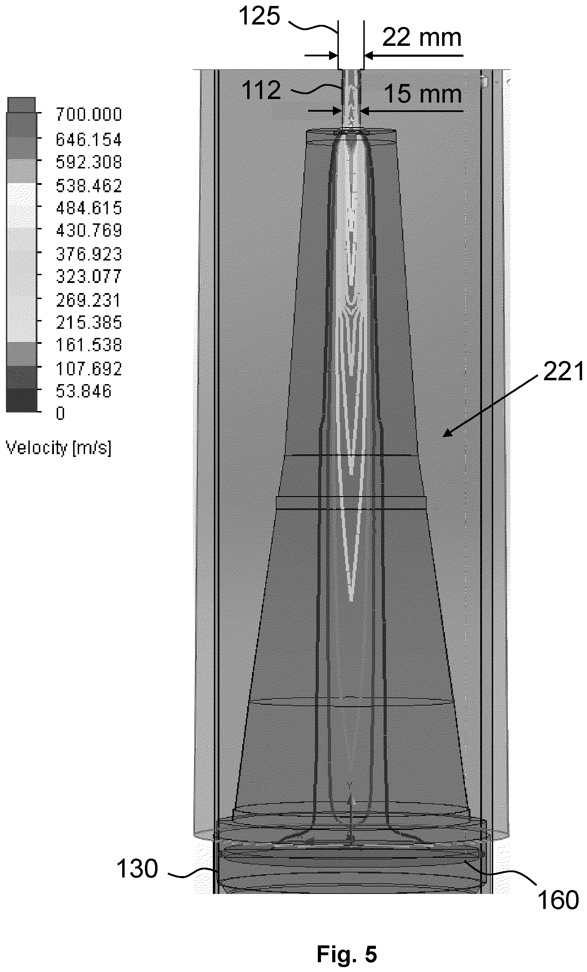

Fig. 5 shows simulation results of gas velocity in an apparatus in accordance with certain embodiments. The apparatus is of the type shown in the preceding Figs. 1-3, especially in Figs. 2-3. Accordingly, the apparatus comprises the plasma source tube 125 followed by the inlet part (with the inner tube 112 shown) with an inner diameter that is narrower than the inner diameter of the tube 125. The inlet part is followed by an expansion volume (part 221, or similar) expanding towards the deposition target 160 in the reaction chamber 130. For the purposes of simulation, the plasma source tube 125 had an inner diameter of 22 mm, and the inner tube 112 an inner diameter of 15 mm. It is observed that gas velocity is not only increased inside the part 112 but also at a relatively long distance downstream the part 112, and even close to the deposition target 160.

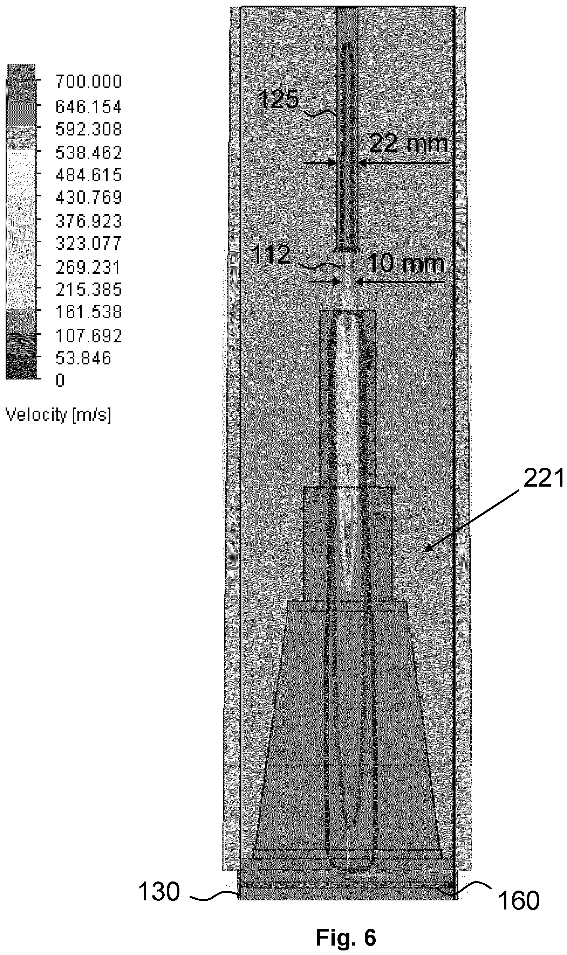

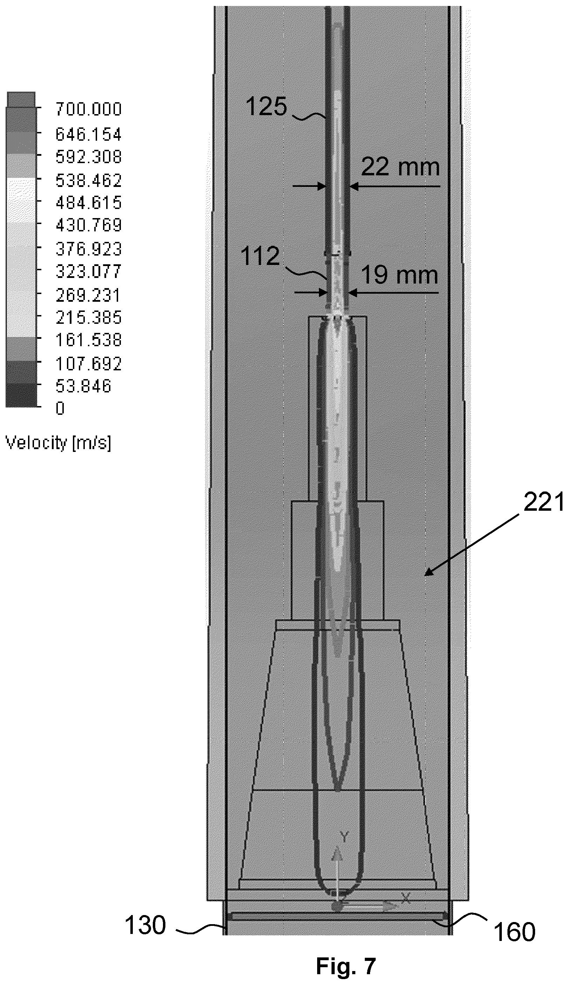

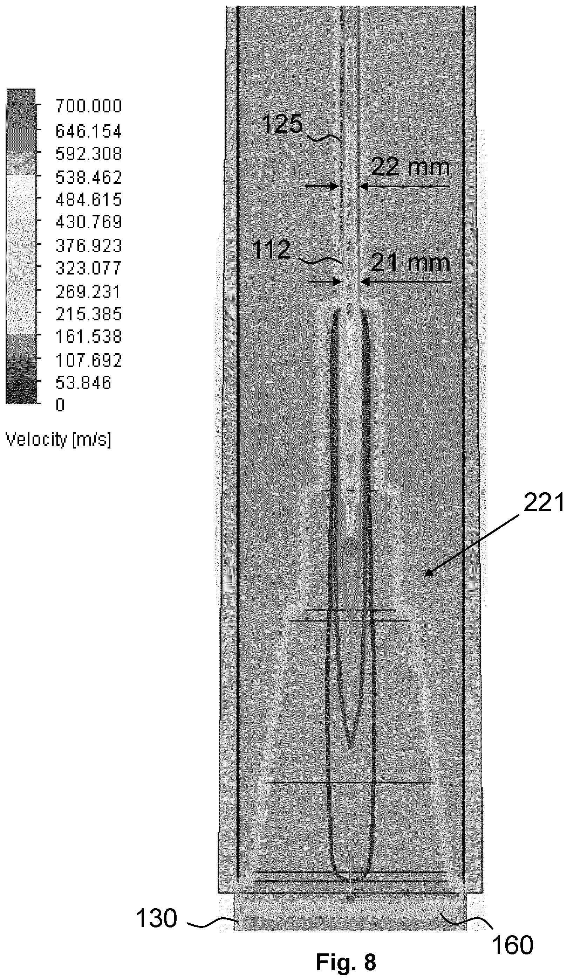

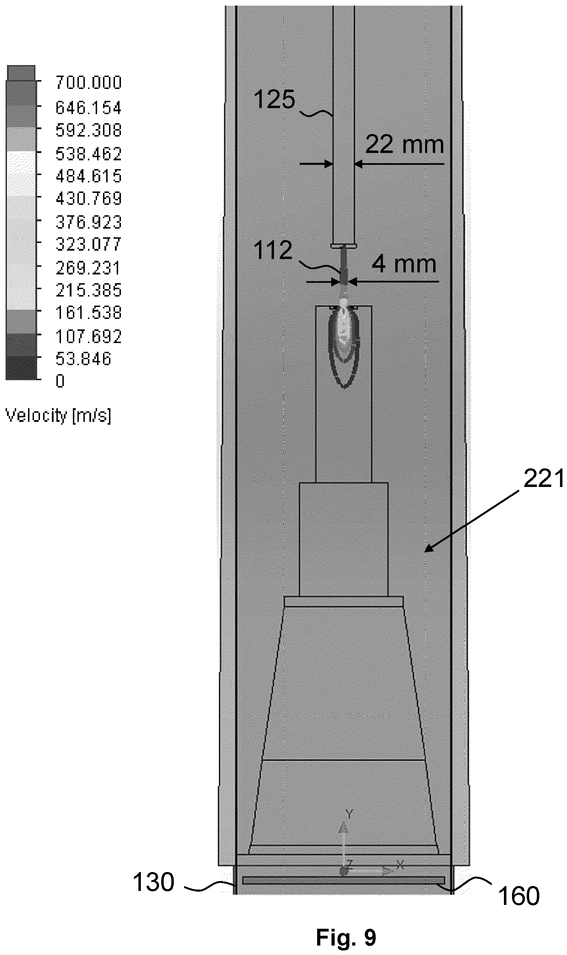

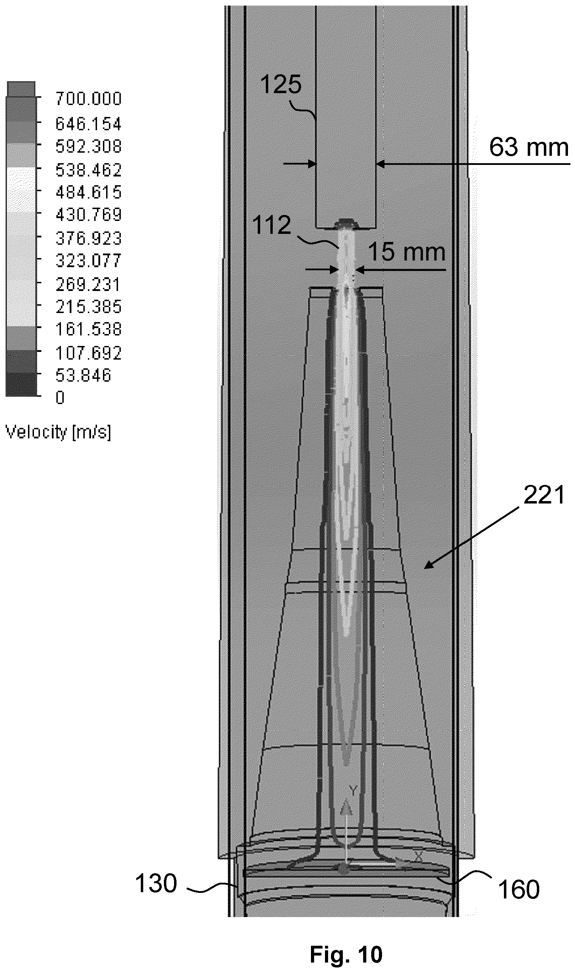

Figs. 6-10 show simulation results of gas velocity in apparatus in accordance with other embodiments. Each of the embodiments shown in Figs. 6-10 show a similar effect. The gas velocity is not only increased inside the part 112 (which acts as a constriction) but also further downstream the part 112. The inner diameter of the plasma source tube 125 in the embodiments shown in Figs. 6-9 is 22 mm, and 63 mm in the embodiment shown in Fig. 10. The inner diameter of the inner tube 112 is 10 mm in the embodiment shown Fig. 6. In the embodiment shown Fig. 7 the inner tube 112 inner diameter is 19 mm. In the embodiment shown Fig. 8 the inner tube inner 112 diameter is 21 mm. In the embodiment shown Fig. 9 the inner tube 112 inner diameter is 4 mm. In the embodiment shown Fig. 10 the inner tube 112 inner diameter is 15 mm.

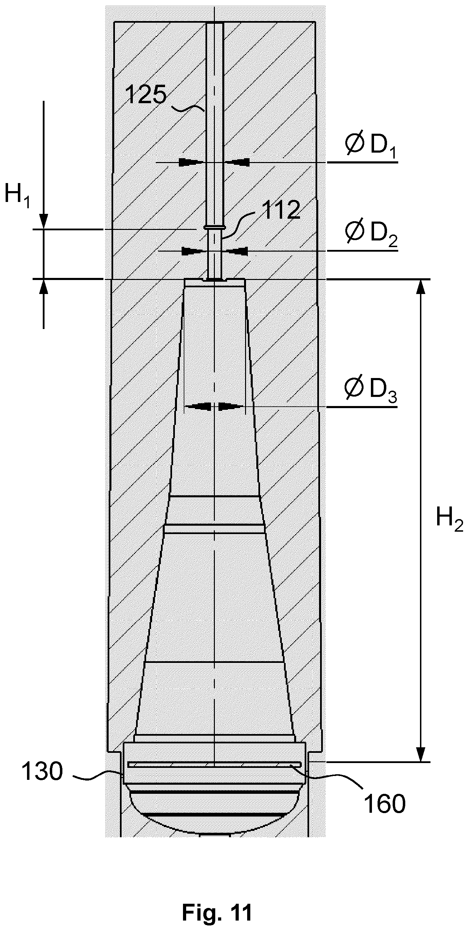

Fig. 11 shows certain dimensions of the apparatus shown in Figs. 5-10. The inner diameter of the plasma source tube 125 is denoted by ∅D₁, the inner diameter of the inner tube 112 by ∅D₂, the length of the inner tube 112 by H₁, the inner diameter of the expansion space 221 at the point of the stepwise enlargement by ∅D₃, and the distance from the reaction chamber side end of the inner tube 112 to the deposition target (or wafer) 160 by H₂.

The inner tube 112 acts as a constriction in the plasma in-feed line.

It has been observed by tests and/or simulations that the effect of speeding up gas velocity has been successful within a wide range of constriction channel diameters ∅D₂. It was observed that the effect was surprisingly obtained also with a very slight narrowing of the flow channel (plasma in-feed line). In fact, when a channel diameter ∅D₁ immediately preceding the constriction 112 was 22 mm the effect was obtained already with the constriction channel diameter value ∅D₂ = 21 mm.

Furthermore, the effect was also obtained with a very large narrowing of the flow channel, i.e., with the constriction channel diameter value ∅D₂ = 4 mm.

Furthermore, surprisingly, the effect was even obtained with larger values of ∅D₁, such as, ∅D₁ = 63 mm.

In certain preferred embodiments, the constriction 112 reduces cross-sectional flow area of the in-feed line 115 by at least 8 %. An 8 % reduction is practically obtained, for example, in embodiments in which ∅D₂ is 21 mm and ∅D₁ is 22 mm.

It has been observed that the effect of speeding up gas velocity was further enhanced when ∅D₂ was within the range from 10 mm to 19 mm when ∅D₁ was 22 mm. Accordingly, in certain more preferred embodiments, a constricted cross-sectional flow area is within the range from 20 % to 75 % of the cross-sectional flow area before the constriction 112.

It has been observed that the effect of speeding up gas velocity was yet further enhanced when ∅D₂ was around 15 mm. Accordingly, in certain yet more preferred embodiments, a constricted cross-sectional flow area is within the range from 40 % to 50 % of the cross-sectional flow area before the constriction 112.

However, the effect was also obtained when ∅D₂ was 4 mm and ∅D₁ was 63 mm - a case scenario in which the flow channel was narrowed by a total of 99.6 %.

In certain preferable embodiments, in which the plasma source tube 125 is generally large (i.e., closer to 63 mm rather than 22 mm) the constricted cross-sectional flow area may be 15% of the cross-sectional flow area before the constriction 112, or less. In certain preferable embodiments, the constricted cross-sectional flow area is within the range from 0.40 % to 15 % of the cross-sectional flow area before the constriction 112.

In certain preferred embodiments, the constriction 112 is of a tubular form with a reduced inner diameter (the inner diameter is reduced compared to the inner diameter(s) of the remaining portion of the in-feed line). In certain preferred embodiments, as mentioned in the preceding, the constriction 112 has a channel diameter ∅D₂ within the range from 4 mm to 21 mm. In certain more preferred embodiments, the constriction 112 has a channel diameter ∅D₂ within the range of 10 mm - 21 mm. In certain embodiments, these values are particularly preferable when coating 8 inch / 200 mm wafers. Accordingly, in certain embodiments, the channel diameter ∅D₂ is within the range from 2 % to 10.5 %, or more preferably from 5 % to 10.5 %, of the diameter of a round substrate, such as wafer. Although the values are particularly preferable for 8 inch / 200 mm wafers, the values and principles presented herein are generally applicable also to other wafer sizes, for example, 12 inch / 300 mm wafers.

In certain more general embodiments, the constriction 112 and the plasma in-feed line 125 preceding the constriction 112 are of tubular form, and the constriction 112 has an inner diameter ∅D₂ within the range from 4 mm to 50 mm, more preferably from 10 mm to 50 mm and the plasma in-feed line 125 preceding the constriction 112 has an inner diameter ∅D₁ larger than the inner diameter ∅D₂ of the constriction 112, and wherein ∅D₁ is selected from an inner diameter range from 20 mm to 100 mm. In certain preferred embodiments, the constriction 112 and the plasma in-feed line preceding the constriction are of tubular form, and the constriction 112 has an inner diameter ∅D₂ within the range from 10 mm to 20 mm and the plasma in-feed line preceding the constriction 112 has an inner diameter ∅D₁ larger than the inner diameter ∅D₂ of the constriction 112 and ∅D₁ is selected from an inner diameter range from 50 mm to 70 mm.

The preferable embodiments relating to the constricted cross-sectional flow area or diameters provide the effect of reduced travel time of plasma species from plasma source to deposition target (compared to solutions that lack the constriction).

It has been observed that many lengths (longitudinal dimension) H₁ of the constriction 112 may be used to obtain the mentioned effect of speeding up gas velocity. However, in general, the length should be large enough to speed up adequately, for example, at least greater than ∅D₂, or more preferably at least two or three times the width ∅D₂. However, the distance to the deposition target should not be unnecessarily lengthened by choosing a far too long length H₁. In certain preferred embodiments, it has been observed that the length ranging from 50 mm to 100 mm is preferable. In more preferred embodiments, the length H₁ within the range from 60 mm to 70 mm has been used.

In certain embodiments, the cross-sectional area of the plasma in-feed line (expansion space 221) immediately after (or downstream of) the constriction 112 is larger than the cross-sectional area of the plasma in-feed line (plasma source tube 125) immediately before (or upstream of) the constriction. In certain embodiments, the expansion space 221 is of a tubular form or has a ring-like or round cross-section. The channel formed by the expansion space expands in width towards the deposition target 160. In certain example embodiments, the width ∅D₁ is within the range from 20 to 70 mm and the width ∅D₃ greater than ∅D₁ and within the range from 70 mm to 200 mm, for example 77 mm.

In certain embodiments, the distance H₂ from the inner tube 112 to the deposition target (or wafer) 160 is at least 30 cm for lateral spreading of the plasma species. In certain more preferred embodiments, the distance H₂ is within the range from 50 cm to 100 cm.

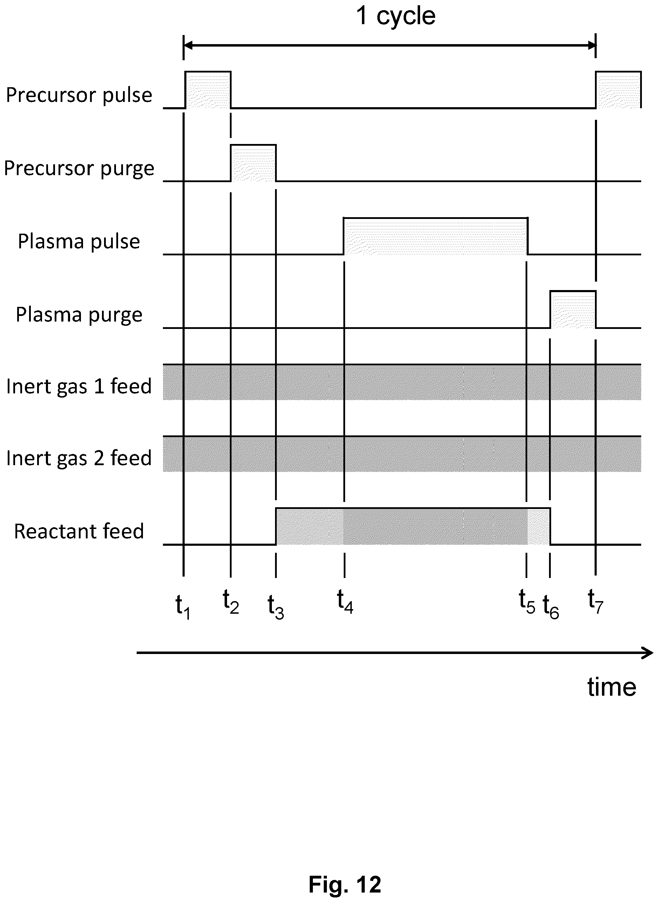

Fig. 12 shows a process timing diagram in accordance with certain embodiments. A plasma-enhanced atomic layer deposition cycle is presented. The cycle begins at time instant t₁ by a precursor pulse. The precursor pulse ends at time instant t₂. During this precursor pulse period, precursor vapor from a precursor source is fed into the reaction chamber to consume the reactive sites of the deposition target. Half a monolayer of material is deposited. The precursor vapor is fed via a route that does not go through the plasma source, i.e., the precursor vapor route to the reaction chamber is separate from the plasma source. The precursor vapor is typically vapor of a metal precursor or a semiconductor precursor. The adsorption method onto the deposition target is typically thermal ALD.

The precursor pulse period is followed by a precursor purge period. During this period, the in-feed line(s) of the precursor vapor is purged by a first inert gas, such as nitrogen N₂ (Inert gas 1). The precursor purge period ends at time instant t₃.

The precursor purge period is followed by a plasma pulse period. The plasma pulse period begins at time instant t₃ and ends at time instant t₆. First, a feed of a plasma gas (plasma reactant, e.g., oxygen O₂) through the plasma source is began. After a gas stabilization period extending to time instant t₄, the power of the plasma source is switched "ON". During a plasma formation period beginning at time instant t₄, the plasma reactant and second inert gas, such as argon Ar (Inert gas 2) is fed through the plasma source along the plasma source tube. Plasma species are formed from the plasma reactant in a plasma formation section during a plasma formation period until the plasma power is switched "OFF" at time instant t₅. The plasma species enter the reaction chamber to react on the surface of the deposition target by the adsorbed precursor. A thin film of a full monolayer is obtained. The adsorption method onto the deposition target is plasma-enhanced ALD.

After a short plasma deactivation period from time instant t₅ to t₆, a plasma purge period starts at time instant t₆. During the plasma deactivation period, both the plasma reactant and the second inert gas flow through the plasma source. However, plasma is not formed since the power of the plasma source is "OFF".

During the plasma purge period from time instant t₆ to t₇, the plasma reactant in-feed through the plasma source is "OFF". The plasma source is purged by the second inert gas. The deposition cycle ends at time instant t₇. The deposition cycle is repeated to obtain a desired film thickness.

In certain embodiments, the flow of both the first inert gas and the second inert gas is "ON" during the whole deposition cycle.

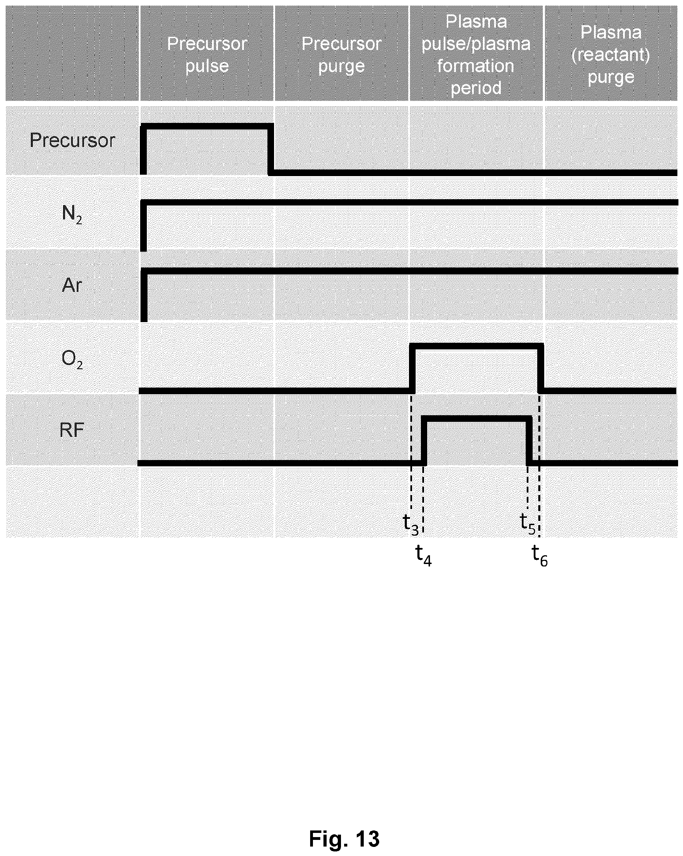

Fig. 13 shows another representation of the timing diagram. Nitrogen N₂ is used as the first inert gas, and argon Ar as the second inert gas. Oxygen containing gas, such as O₂, is used as the plasma reactant to deposit an oxide. During the plasma formation period (from time instant t₄ to t₅) the plasma power (radio frequency, RF, power in this embodiment) is "ON" to produce O* plasma. Depending on the used precursor, an oxide thin film is formed. For example, by using Bis(diethylamino)silane SiH₂[N(CH₂CH₃)₂]₂ as the precursor, a silicon oxide SiO₂ thin film is obtained.

Accordingly, in certain embodiments oxygen containing gas, such as O₂, is used as the plasma reactant, and Si containing precursor is used as the other precursor to deposit SiO₂. In other embodiments, oxygen containing gas, such as O₂, is used as the plasma reactant, and an aluminum containing precursor is used as the other precursor to deposit Al₂O₃. An example of an aluminum containing precursor is TMA (Al(CH₃)₃). Further applicable oxide coatings are, e.g., TiO₂, HfO₂, Y₂O₃, Co₃O₄, Ta₂O₅, MgO₂, ZrO₂, La₃O₃. Furthermore, nitrogen containing gas, e.g., N₂, NH₃ or N₂/H₂ is used as the plasma reactant in other embodiments to deposit nitride thin films. Depending on the used other precursor, nitride thin films such as AlN, TiN, Si₃N₄ are formed. In other embodiments, elemental Pt, Ir, or Ru is deposited. In these embodiments, inter alia, the plasma reactant does not function as a precursor but is merely used as a means to provide required missing reaction energy to deposit the desired thin film material.

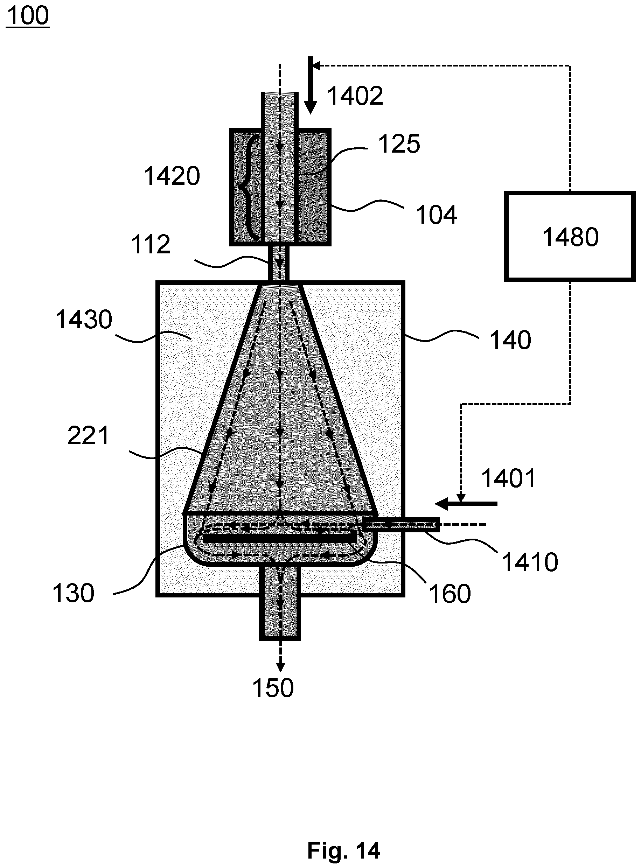

Fig. 14 shows another representation of the apparatus 100 in accordance with certain embodiments. The plasma reactant and the second inert gas enter the plasma source tube 125 of the plasma source 104 as depicted by an arrow 1402. The plasma species are formed in a plasma forming section 1420 of the plasma source 104. The apparatus 100 comprises the widening expansion space 221 on top of the reaction chamber 130. After having passed through the constriction 112, the formed plasma species flow through the expansion space 221 downwards to the reaction chamber 130 to react on the surface of the deposition target (a wafer, or another substrate) 160.

Similarly, the precursor (non-plasma precursor) and the first inert gas enter the reaction chamber 130 as depicted by an arrow 1401 via an in-feed part 1410. In certain embodiments, the in-feed of the precursor into the reaction chamber 130 is from a side or from sides of the reaction chamber 130 whilst the flow direction of the plasma species to the reaction chamber is from the top of the reaction chamber. The in-feed part 1410 may be an inlet positioned in a side wall of the reaction chamber 1430. An intermediate space between the wall of the reaction chamber 130 and the wall of the outer chamber 140 is denoted by reference numeral 1430.

The first and/or second inert gases may act as a carrier gas for the corresponding precursor or reactant.

The operation of the apparatus is controlled by a control system 1480.

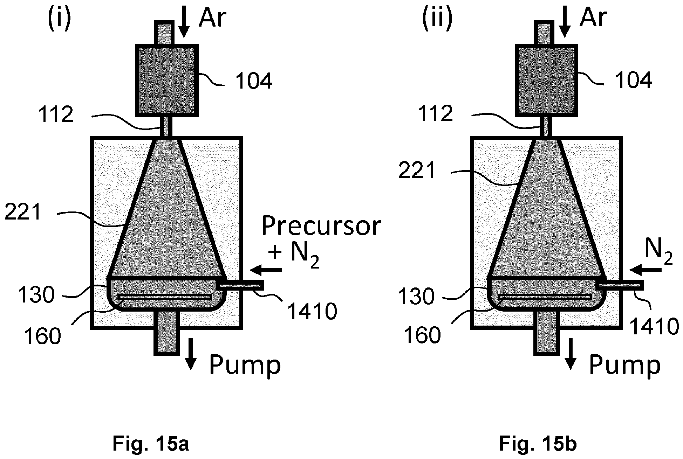

Figs. 15a-15d further demonstrate the operation of the apparatus 100 in accordance with certain embodiments.

Fig. 15a shows gas flow configurations during (i) precursor pulse period. The (non-plasma) precursor and first inert gas (here: N₂) flow via the in-feed part 1410 into the reaction chamber 130 towards the deposition target 160. The second inert gas (here: Ar) flows via the (unpowered) plasma source 104 towards the deposition target 160.

Fig. 15b shows gas flow configurations during (ii) precursor purge period. The first inert gas (here: N₂) flows via the in-feed part 1410 into the reaction chamber 130. The second inert gas (here: Ar) flows via the (unpowered) plasma source 104 towards the deposition target 160.

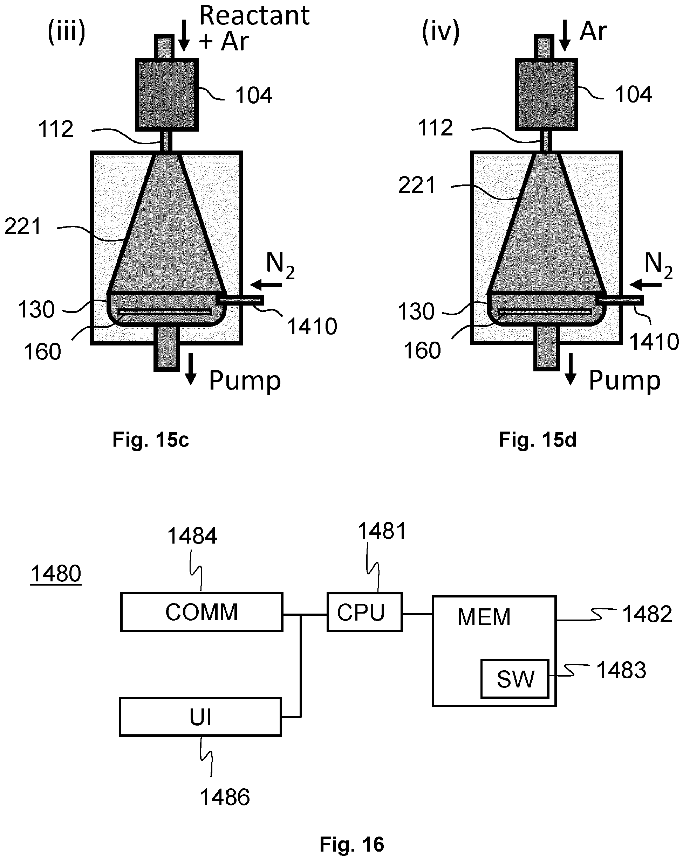

Fig. 15c shows gas flow configurations during (iii) plasma pulse, i.e., plasma formation period. The first inert gas (here: N₂) flows via the in-feed part 1410 into the reaction chamber 130. The plasma reactant and second inert gas (here: Ar) flow into the plasma source 104 for excitation by RF radiation. Plasma species produced from the plasma reactant gas and the second inert gas flow from the plasma source 104 to the reaction chamber 130.

Fig. 15d shows gas flow configurations during (iv) plasma purge period. The first inert gas (here: N₂) flows via the in-feed part 1410 into the reaction chamber 130. The second inert gas (here: Ar) flows via the (unpowered) plasma source 104 towards the deposition target 160.

Fig. 16 shows a block diagram of the control system 1480 in accordance with certain example embodiments. The control system 1480 comprises at least one processor 1481 to control the operation of the apparatus 100. The control system further comprises at least one memory 1482 comprising a computer program or software 1483. The software 1483 includes instructions or a program code to be executed by the at least one processor 1481 to control the apparatus 100. The software 1483 may typically comprise an operating system and different applications.

The at least one memory 1481 may form part of the apparatus 100 or it may comprise an attachable module. The control system 1480 further comprises at least one communication unit 1484. The communication unit 1484 provides for an interface for internal communication of the apparatus 100. In certain example embodiments, the control unit 1480 uses the communication unit 1484 to send instructions or commands to and to receive data from different parts of the apparatus 100, for example, measuring and control devices, valves, pumps, and heaters, as the case may be.

The control system 1480 may further comprise a user interface 1486 to co-operate with a user, for example, to receive input such as process parameters from the user.

As to the operation of the apparatus 100, the control system 1480 controls e.g. the process timings of the apparatus, controls the opening and closing of valves, controls substrate loading and unloading, sets flow rates, sets plasma power, and controls pressures and temperatures in different parts of the apparatus 100.

In certain preferred embodiments, the flow rate of plasma gas entering the plasma formation section 1420 is within the range from 500 sccm to 10000 sccm, more preferably from 4000 sccm to 10000 sccm. It has been observed that greater flow rate contributes to both to the quality of the deposited thin film in terms of low leakage current as well as low non-uniformity of the film. Further, it has been observed that the greater flow rate together with using the constriction 112 provides very good results in terms of low leakage current and low non-uniformity of the film.

In certain preferred embodiments, a plasma power within the range from10 W to 10000 W, preferably from 300 W to 1000 W, more preferably from 300 W to 500 W, or from 1000 W to 10000 W, more preferably from 2000 W to 10000 W, yet more preferably from 3000 W to 10000 W is applied to the plasma formation section 1420. It has been observed that greater plasma power contributes to the quality of the deposited thin film in terms of low leakage current (through higher plasma density). However, a moderate plasma power, i.e., from 300 W to 1000 W, more preferably from 300 W to 500 W did provide good results in terms of non-uniformity of the film. Further, it has been observed that the greater plasma power together with using the constriction 112 provides very good results in terms of low leakage current, also if combined with the flow rate of the plasma gas within the range from 4000 sccm to 10000 sccm. Further, it has been observed that the moderate plasma power together with using the constriction 112 provides very good results in terms of low non-uniformity, also if combined with the flow rate of the plasma gas within the range from 4000 sccm to 10000 sccm.

In certain example embodiments, the plasma formation period with a duration within the range from 0.1 seconds to 60 seconds is applied. However, in certain other embodiments, the plasma formation period may be longer or much longer.

In certain preferred embodiments, the plasma formation period is within the range from 5 seconds to 10 seconds. The plasma formation period within this range has been observed to contribute to low non-uniformity of the deposited thin film. In certain preferred embodiments, the plasma formation period is within the range from 20 seconds to 40 seconds. The plasma formation period within this range has been observed to contribute to low leakage current of the film.

Further, it has been observed that with the plasma formation period ranging from 5 seconds to 10 seconds together with using the constriction 112, also if combined with the flow rate of the plasma gas within the range from 4000 sccm to 10000 sccm, and also optionally combined with the plasma power ranging from 300 W to 1000 W, preferably from 300 W to 500 W, particularly low values of non-uniformity were obtained. Further, it has been observed that with the plasma formation period ranging from 20 seconds to 40 seconds together with using the constriction 112, also if combined with the flow rate of the plasma gas within the range from 4000 sccm to 10000 sccm, and also optionally combined with the plasma power ranging from 1000 W to 10000 W, preferably from 2000 W to 10000 W, more preferably from 3000 W to 10000 W, particularly low leakage current values were obtained.

In certain preferred embodiments, a purge period of a non-plasma precursor with a duration within the range from 1 second to 8 seconds, preferably from 4 seconds to 8 seconds, is applied. It has been observed that the non-plasma precursor purge period ranging from 4 seconds to 8 seconds contributes to both to the quality of the deposited thin film in terms of low leakage current as well as low non-uniformity of the film. Further, it has been observed that the non-plasma precursor purge period ranging from 4 seconds to 8 seconds together with using the constriction 112, optionally with using the flow rate of the plasma gas within the range from 4000 sccm to 10000 sccm, provides very good results in terms of low leakage current and low non-uniformity of the film.

In certain preferred embodiments, the constriction 112 is used together with the following set of process parameters: the flow rate of plasma gas entering the plasma formation section 1420 is within the range from 500 sccm to 10000 sccm, a plasma power within the range from 10 W to 10000 W is applied to the plasma formation section 1420, a plasma formation period (plasma pulse) with a duration within the range from 0.1 seconds to 60 seconds is applied, and a purge period of a non-plasma precursor with a duration within the range from 1 second to 8 seconds is applied. The combination may be used to obtain low values of non-uniformity of the deposited thin film and/or low values of leakage current through the film.

In certain preferred embodiments, the constriction 112 is used together with the following set of process parameters: the flow rate of plasma gas entering the plasma formation section 1420 is within the range from 4000 sccm to 10000 sccm, a plasma power within the range from 300 W to 1000 W, preferably from 300 W to 500 W, is applied to the plasma formation section 1420, a plasma formation period with a duration within the range from 5 seconds to 10 seconds is applied, and a purge period of a non-plasma precursor with a duration within the range from 4 seconds to 8 seconds is applied. The combination may be used to obtain particularly low values of non-uniformity of the deposited thin film.

In certain preferred embodiments, the constriction 112 is used together with the following set of process parameters: the flow rate of plasma gas entering the plasma formation section 1420 is within the range from 4000 sccm to 10000 sccm, a plasma power within the range from 1000 W to 10000 W, preferably from 2000 W to 10000 W, more preferably from 3000 W to 10000 W is applied to the plasma formation section 1420, a plasma formation period with a duration within the range from 20 seconds to 40 seconds is applied, and a purge period of a non-plasma precursor with a duration within the range from 4 seconds to 8 seconds is applied. The combination may be used to obtain particularly low values of leakage current through the deposited thin film.

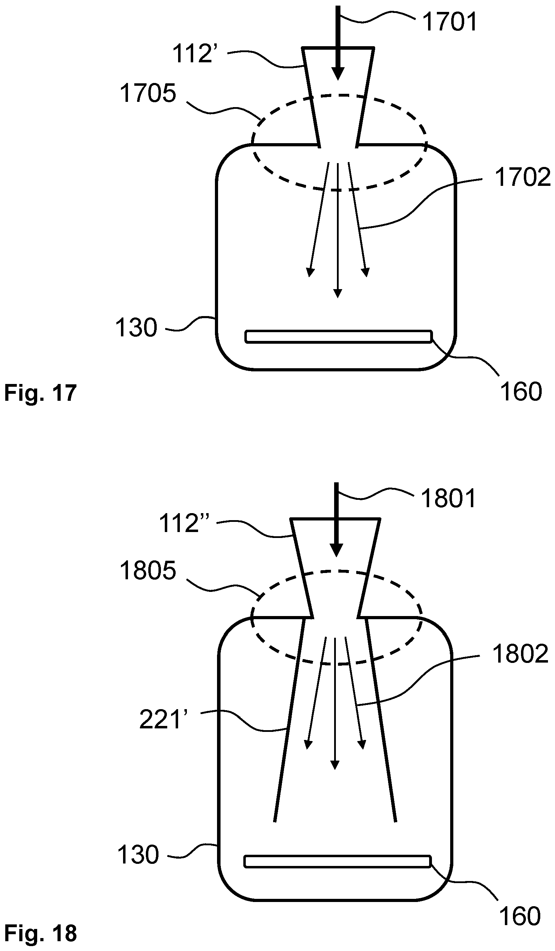

Fig. 17 shows a schematic drawing of an apparatus in accordance with certain further embodiments. In these embodiments, the inlet part 110 (see Figs. 1-4 in the preceding) is implemented by a converging nozzle arrangement 1705. In an embodiment as shown in Fig. 17, the plasma reactant (or formed plasma species) enters a nozzle part 112' (as depicted by arrow 1701). The nozzle part 112' may be otherwise similar to the inner tube or inlet liner 112 described in the preceding but, instead of a flow channel with an unchanging geometry and diameter, the nozzle part 112' provides a converging channel. As an example, the nozzle part 112' may contain an upside-down placed truncated cone 112' that forms a converging flow channel therein. The gas velocity accelerates within the converging channel provided by the nozzle part 112'. At the reaction chamber end of the nozzle part 112', the flow channel comprises a stepwise widening of the flow channel (flow path). At this point the plasma species is released with an increased velocity towards the deposition target 160 (in the reaction chamber 130) as depicted by arrows 1702. The in-feed of non-plasma precursor(s) into the reaction chamber 130 is arranged via another route (i.e., a route not passing through the converging nozzle arrangement 1705). In certain embodiments, the in-feed of non-plasma precursor(s) is arranged (downstream of the converging nozzle arrangement 1705) from a side or from sides of the reaction chamber 130 whilst the flow direction of the plasma species to the reaction chamber is from the top of the reaction chamber.

Fig. 18 shows a schematic drawing of an apparatus in accordance with certain further embodiments. In these embodiments, instead of the converging nozzle arrangement 1705, the apparatus comprises a converging-diverging nozzle arrangement 1805. In an embodiment as shown in Fig. 18, the plasma reactant (or formed plasma species) enters a nozzle part 112" (as depicted by arrow 1801). The nozzle part 112" may be otherwise similar to the nozzle part 112' but, instead of a mere converging channel provided by part 112', the nozzle part 112" provides a converging channel followed by a diverging (expanding, in volume) channel. In certain embodiments, the converging and diverging channel parts comprise an interface therebetween which provides a stepwise widening of the flow channel (flow path). The stepwise widening is to prevent plasma recombination by collisions to the flow channel side wall(s). As an example, the nozzle part 112" may contain an upside-down placed truncated cone that forms a converging flow channel, and followed by another truncated cone 221' that forms a diverging (expanding) flow channel therein. The gas velocity accelerates within the converging channel provided by the nozzle part 112". At the interface between the converging and diverging channels, the plasma species is released with an increased velocity towards the deposition target 160 (positioned within the reaction chamber 130) as depicted by arrows 1802. The in-feed of non-plasma precursor(s) into the reaction chamber 130 is arranged via another route (i.e., a route not passing through the converging-diverging nozzle arrangement 1805). In certain embodiments, the in-feed of non-plasma precursor(s) is arranged (downstream of the converging-diverging nozzle arrangement 1805) from a side or from sides of the reaction chamber 130 whilst the flow direction of the plasma species to the reaction chamber is from the top of the reaction chamber. With the converging-diverging nozzle arrangement 1805 even a supersonic gas jet is possible.

The presented converging nozzle feature and converging-diverging nozzle feature presented in the embodiments shown in Figs. 17 and 18 are applicable in all other presented embodiments. Similarly, features of the other embodiments are applicable in the embodiments shown in Figs. 17 and 18.

Without limiting the scope and interpretation of the patent claims, certain technical effects of one or more of the example embodiments disclosed herein are listed in the following. A technical effect is providing improved reaction species delivery to the deposition target. A further technical effect is forming a chemically resistant barrier layer between metal parts and reactive plasma species. A further technical effect is providing thin films with attractive properties, such as low non-uniformity, and low leakage current.

The foregoing description has provided by way of non-limiting examples of particular implementations and embodiments of the invention a full and informative description of the best mode presently contemplated by the inventors for carrying out the invention. It is however clear to a person skilled in the art that the invention is not restricted to details of the embodiments presented above, but that it can be implemented in other embodiments using equivalent means without deviating from the characteristics of the invention.

Furthermore, some of the features of the above-disclosed embodiments of this invention may be used to advantage without the corresponding use of other features. As such, the foregoing description should be considered as merely illustrative of the principles of the present invention, and not in limitation thereof. Hence, the scope of the invention is only restricted by the appended patent claims.

## Claims

1. A method, comprising:
introducing plasma species via a plasma in-feed line (115) into a reaction chamber (130) for a deposition target (160) in a substrate processing apparatus (100), wherein the plasma in-feed line (115) goes via a plasma formation section (1420), the method being **characterized in that** it comprises: speeding up velocity of plasma species within the plasma in-feed line (115) and downstream from the plasma in-feed line (115) by a constriction (112) of a tubular form providing a straight cylindrical channel downstream of the plasma formation section (1420), wherein the constriction (112) within the plasma in-feed line (115) reduces a cross-sectional flow area of the plasma in-feed line (115) by at least 8 %.

2. The method of claim 1, where the flow rate of plasma gas entering the plasma formation section (1420) is within the range from 500 sccm to 10000 sccm, preferably from 4000 sccm to 10000 sccm.

3. The method of claim 1 or 2, where a plasma power within the range from 10 W to 10000 W, preferably from 300 W to 1000 W, more preferably from 300 W to 500 W, or from 1000 W to 10000 W, more preferably from 2000 W to 10000 W, yet more preferably from 3000 W to 10000 W is applied to the plasma formation section (1420).

4. The method of any preceding claim, where a plasma formation period with a duration within the range from 0.1 seconds to 60 seconds is applied.

5. The method of any preceding claim, where a purge period of a non-plasma precursor with a duration within the range from 1 second to 8 seconds, preferably from 4 seconds to 8 seconds, is applied.

6. The method of claim 1, where the flow rate of plasma gas entering the plasma formation section (1420) is within the range from 500 sccm to 10000 sccm, a plasma power within the range from 10 W to 10000 W is applied to the plasma formation section (1420), a plasma formation period with a duration within the range from 0.1 seconds to 60 seconds is applied, and a purge period of a non-plasma precursor with a duration within the range from 1 second to 8 seconds is applied.

7. The method of claim 1, where the flow rate of plasma gas entering the plasma formation section (1420) is within the range from 4000 sccm to 10000 sccm, a plasma power within the range from 300 W to 1000 W, preferably from 300 W to 500 W, is applied to the plasma formation section (1420), a plasma formation period with a duration within the range from 5 seconds to 10 seconds is applied, and a purge period of a non-plasma precursor with a duration within the range from 4 seconds to 8 seconds is applied.

8. The method of claim 1, where the flow rate of plasma gas entering the plasma formation section (1420) is within the range from 4000 sccm to 10000 sccm, a plasma power within the range from 1000 W to 10000 W, preferably from 2000 W to 10000 W, more preferably from 3000 W to 10000 W is applied to the plasma formation section (1420), a plasma formation period with a duration within the range from 20 seconds to 40 seconds is applied, and a purge period of a non-plasma precursor with a duration within the range from 4 seconds to 8 seconds is applied.

9. A substrate processing apparatus (100), comprising:
a reaction chamber (130);
a plasma in-feed line (115) to introduce plasma species into the reaction chamber (130) for a deposition target (160), wherein the plasma in-feed line (115) goes via a plasma formation section, the apparatus being **characterized in that** the plasma in-feed line (115) comprises a constriction (112) of a tubular form providing a straight cylindrical channel downstream of the plasma formation section (1420) to speed up velocity of plasma species within the plasma in-feed line (115) and downstream from the plasma in-feed line, wherein the constriction (112) within the plasma in-feed line (115) is configured to reduce a cross-sectional flow area of the plasma in-feed line (115) by at least 8 %.

## Patentansprüche

1. Verfahren, umfassend:
Einbringen von Plasmaspezies über eine Plasmazufuhrleitung (115) in eine Reaktionskammer (130) für ein Abscheidungsziel (160) in einer Substratverarbeitungsvorrichtung (100), wobei die Plasmazufuhrleitung (115) über einen Plasmabildungsabschnitt (1420) verläuft, wobei das Verfahren **dadurch gekennzeichnet ist, dass** es umfasst: Beschleunigen der Geschwindigkeit von Plasmaspezies in der Plasmazufuhrleitung (115) und stromabwärts von der Plasmazufuhrleitung (115) durch eine Verengung (112) einer Röhrenform, die stromabwärts von dem Plasmabildungsabschnitt (1420) einen geraden zylindrischen Kanal bereitstellt, wobei die Verengung (112) in der Plasmazufuhrleitung (115) eine Querschnitts-Strömungsfläche der Plasmazufuhrleitung (115) um mindestens 8 % verringert.

2. Verfahren nach Anspruch 1, wobei die Durchflussmenge des in den Plasmabildungsabschnitt (1420) eintretenden Plasmagases in dem Bereich von 500 sccm bis 10000 sccm, bevorzugt von 4000 sccm bis 10000 sccm, liegt.

3. Verfahren nach Anspruch 1 oder 2, wobei eine Plasmaleistung in dem Bereich von 10 W bis 10000 W, bevorzugt von 300 W bis 1000 W, besonders bevorzugt von 300 W bis 500 W, oder von 1000 W bis 10000 W, besonders bevorzugt von 2000 W bis 10000 W, noch mehr besonders bevorzugt von 3000 W bis 10000 W, auf den Plasmabildungsabschnitt (1420) angewendet wird.

4. Verfahren nach einem der vorhergehenden Ansprüche, wobei eine Plasmabildungsperiode mit einer Dauer in dem Bereich von 0,1 Sekunden bis 60 Sekunden angewendet wird.

5. Verfahren nach einem der vorhergehenden Ansprüche, wobei eine Spülperiode eines Nicht-Plasma-Vorläufers mit einer Dauer in dem Bereich von 1 Sekunde bis 8 Sekunden, bevorzugt von 4 Sekunden bis 8 Sekunden, angewendet wird.

6. Verfahren nach Anspruch 1, wobei die Durchflussmenge des in den Plasmabildungsabschnitt (1420) eintretenden Plasmagases in dem Bereich von 500 sccm bis 10000 sccm liegt, eine Plasmaleistung in dem Bereich von 10 W bis 10000 W auf den Plasmabildungsabschnitt (1420) angewendet wird, eine Plasmabildungsperiode mit einer Dauer in dem Bereich von 0,1 Sekunden bis 60 Sekunden angewendet wird und eine Spülperiode eines Nicht-Plasma-Vorläufers mit einer Dauer in dem Bereich von 1 Sekunde bis 8 Sekunden angewendet wird.

7. Verfahren nach Anspruch 1, wobei die Durchflussmenge des in den Plasmabildungsabschnitt (1420) eintretenden Plasmagases in dem Bereich von 4000 sccm bis 10000 sccm liegt, eine Plasmaleistung in dem Bereich von 300 W bis 1000 W, bevorzugt von 300 W bis 500 W, auf den Plasmabildungsabschnitt (1420) angewendet wird, eine Plasmabildungsperiode mit einer Dauer in dem Bereich von 5 Sekunden bis 10 Sekunden angewendet wird und eine Spülperiode eines Nicht-Plasma-Vorläufers mit einer Dauer in dem Bereich von 4 Sekunden bis 8 Sekunden angewendet wird.

8. Verfahren nach Anspruch 1, wobei die Durchflussmenge des in den Plasmabildungsabschnitt (1420) eintretenden Plasmagases in dem Bereich von 4000 sccm bis 10000 sccm liegt, eine Plasmaleistung in dem Bereich von 1000 W bis 10000 W, bevorzugt von 2000 W bis 10000 W, besonders bevorzugt von 3000 W bis 10000 W, auf den Plasmabildungsabschnitt (1420) angewendet wird, eine Plasmabildungsperiode mit einer Dauer in dem Bereich von 20 Sekunden bis 40 Sekunden angewendet wird und eine Spülperiode eines Nicht-Plasma-Vorläufers mit einer Dauer in dem Bereich von 4 Sekunden bis 8 Sekunden angewendet wird.

9. Substratverarbeitungsvorrichtung (100), umfassend:
eine Reaktionskammer (130);
eine Plasmazufuhrleitung (115) zum Einbringen von Plasmaspezies in die Reaktionskammer (130) für ein Abscheidungsziel (160), wobei die Plasmazufuhrleitung (115) über einen Plasmabildungsabschnitt verläuft, wobei die Vorrichtung **dadurch gekennzeichnet ist, dass** die Plasmazufuhrleitung (115) eine Verengung (112) in Röhrenform umfasst, die stromabwärts von dem Plasmabildungsabschnitt (1420) einen geraden zylindrischen Kanal bereitstellt, um die Geschwindigkeit von Plasmaspezies in der Plasmazufuhrleitung (115) und stromabwärts von der Plasmazufuhrleitung zu beschleunigen, wobei die Verengung (112) in der Plasmazufuhrleitung (115) so konfiguriert ist, dass sie eine Querschnitts-Strömungsfläche der Plasmazufuhrleitung (115) um mindestens 8 % verringert.

## Revendications

1. Un procédé, comprenant :
le fait d'introduire des espèces plasmatiques via une conduite (115) d'alimentation en plasma dans une chambre de réaction (130) pour une cible de dépôt (160) dans un appareil (100) de traitement de substrat, la conduite (115) d'alimentation en plasma passant par une section (1420) de formation de plasma, le procédé étant **caractérisé en ce qu'**il comprend : le fait d'accélérer la vitesse des espèces plasmatiques dans la conduite (115) d'alimentation en plasma et en aval de la conduite (115) d'alimentation en plasma, par un rétrécissement (112) d'une forme tubulaire fournissant un canal cylindrique droit en aval de la section (1420) de formation de plasma, le rétrécissement (112) dans la conduite (115) d'alimentation en plasma réduisant une zone d'écoulement transversale de la conduite (115) d'alimentation en plasma d'au moins 8 %.

2. Le procédé selon la revendication 1, dans lequel le débit de gaz plasma entrant dans la section (1420) de formation de plasma est compris entre 500 sccm et 10000 sccm, de préférence entre 4000 sccm et 10000 sccm.

3. Le procédé selon la revendication 1 ou la revendication 2, dans lequel une puissance de plasma, comprise entre 10 W et 10000 W, de préférence entre 300 W et 1000 W, de façon encore préférée entre 300 W et 500 W, ou entre 1000 W et 10000 W, de façon encore préférée entre 2000 W et 10000 W, de façon encore préférée, entre 3000 W et 10000 W, est appliquée à la section (1420) de formation de plasma.

4. Le procédé selon l'une quelconque des revendications précédentes, dans lequel une période de formation de plasma d'une durée comprise entre 0,1 seconde et 60 secondes est appliquée.

5. Le procédé selon l'une quelconque des revendications précédentes, dans lequel une période de purge d'un précurseur non plasmatique d'une durée comprise entre 1 seconde et 8 secondes, de préférence entre 4 secondes et 8 secondes, est appliquée.

6. Le procédé selon la revendication 1, dans lequel le débit de gaz plasma entrant dans la section (1420) de formation de plasma est compris entre 500 sccm et 10000 sccm, une puissance plasmatique comprise entre 10 W et 10000 W est appliquée à la section (1420) de formation de plasma, une période de formation de plasma d'une durée comprise entre 0,1 seconde et 60 secondes est appliquée, et une période de purge d'un précurseur non-plasmatique d'une durée comprise entre 1 seconde et 8 secondes est appliquée.

7. Le procédé selon la revendication 1, dans lequel le débit de gaz plasma entrant dans la section (1420) de formation de plasma est compris entre 4000 sccm et 10000 sccm, une puissance de plasma comprise entre 300 W et 1000 W, de préférence entre 300 W et 500 W, est appliquée à la section (1420) de formation de plasma, une période de formation de plasma d'une durée comprise entre 5 et 10 secondes est appliquée, et une période de purge d'un précurseur non-plasmatique d'une durée comprise entre 4 et 8 secondes est appliquée.

8. Le procédé selon la revendication 1, dans lequel le débit de gaz plasma entrant dans la section (1420) de formation de plasma est compris entre 4000 sccm et 10000 sccm, une puissance de plasma comprise entre 1000 W et 10000 W, de préférence entre 2000 W et 10000 W, de façon encore préférée entre 3000 W et 10000 W est appliquée à la section (1420) de formation de plasma, une période de formation de plasma d'une durée comprise entre 20 et 40 secondes est appliquée, et une période de purge d'un précurseur non-plasmatique d'une durée comprise entre 4 et 8 secondes est appliquée.

9. Un appareil (100) de traitement de substrat, comprenant :
une chambre de réaction (130) ;
une conduite (115) d'alimentation en plasma pour introduire des espèces plasmatiques dans la chambre de réaction (130) pour une cible de dépôt (160), la conduite (115) d'alimentation en plasma passant par une section de formation de plasma, l'appareil étant **caractérisé en ce que** la conduite (115) d'alimentation en plasma comprend un rétrécissement (112) d'une forme tubulaire fournissant un canal cylindrique droit en aval de la section (1420) de formation de plasma pour accélérer la vitesse des espèces plasmatiques dans la conduite (115) d'alimentation en plasma et en aval de la conduite d'alimentation en plasma, le rétrécissement (112) dans la conduite (115) d'alimentation en plasma étant configuré pour réduire une zone d'écoulement transversale de la conduite (115) d'alimentation en plasma d'au moins 8 %.
